# DEMANDE DE BREVET EUROPEEN

(11) **EP 3 614 205 A1**
(43) Date de publication de la demande: **26.02.2020**
(21) Numéro de dépôt: 18190253.7
(22) Date de dépôt: 22.08.2018
(51) Int. Cl.: G03F 7/00, C25D 1/00, C25D 5/02

(54) **PROCEDE DE FABRICATION D'UN COMPOSANT HORLOGER ET COMPOSANT OBTENU SELON CE PROCEDE**

(71) Demandeur: Nivarox-FAR S.A., 2400 Le Locle (CH)
(72) Inventeur: Golfier, Clare, 2520 La Neuveville (CH); Salihu, Fatmir, 2000 Neuchâtel (CH); Cusin, Pierre, 1423 Villars-Burquin (CH)
(74) Mandataire: ICB SA

(57) **Abrégé**

La présente invention concerne un procédé de fabrication de composant horloger métalliques caractérisé en ce qu'il comprend les étapes consistant à former par un procédé du type LIGA-UV un moule en résine photosensible multiniveau et à déposer galvaniquement une couche d'au moins un métal à partir d'au moins deux couches conductrices pour former un bloc atteignant sensiblement la surface supérieure de la résine photosensible.

## Description

### Domaine de l'invention

La présente invention concerne un procédé de fabrication d'une structure métallique multi-niveaux au moyen de la technologie LIGA. L'invention concerne également une telle structure métallique, notamment des composants horlogers, obtenus par ce procédé.

### Arrière-plan de l'invention

On connaît déjà des procédés correspondant à la définition ci-dessus. En particulier, l'article d'A. B. Frazier et al. intitulé « Metallic Microstuctures Fabricated Using Photosensitive Polyimide Electroplating molds » et publié dans le journal of Microelectromechanical systems (Vol. 2, N deg. 2, June 1993) décrit un procédé pour la fabrication de structures métalliques multi-niveaux par croissance galvanique dans des moules de polyimide réalisés par photolithographie de couches de résine photosensible. Ce procédé comprend les étapes suivantes :
- créer sur un substrat une couche métallique sacrificielle et une couche d'amorçage pour une étape ultérieure de croissance galvanique,
- étaler une couche de polyimide photosensible,
- irradier la couche de polyimide avec un rayonnement UV à travers un masque correspondant au contour d'un niveau de la structure à obtenir,
- développer la couche de polyimide en dissolvant les parties non irradiées de façon à obtenir un moule en polyimide,
- remplir le moule de nickel jusqu'à la hauteur de celui-ci par croissance galvanique, et obtenir une surface supérieure sensiblement plane,
- déposer une fine couche de chrome sur toute la surface supérieure par vaporisation sous vide,
- déposer sur la couche de chrome une nouvelle couche de résine photosensible,
- irradier la couche de résine à travers un nouveau masque correspondant au contour du niveau suivant de la structure à obtenir,
- développer la couche de polyimide de façon à obtenir un nouveau moule,
- remplir le nouveau moule de nickel jusqu'à la hauteur de celui-ci par croissance galvanique.
- séparer la structure multi-niveaux et le moule en polyimide de la couche sacrificielle et du substrat,
- séparer la structure multi-niveaux du moule en polyimide.

On comprendra que le procédé qui vient d'être décrit peut, en principe, être mis en oeuvre de manière itérative pour obtenir des structures métalliques ayant plus de deux niveaux. Un inconvénient de ce procédé et la nécessité d'obtenir une surface supérieure sensiblement plane lors de chaque étape de dépôt galvanique.

Le document de brevet WO2010/020515A1 décrit la fabrication d'une pièce à plusieurs niveaux en réalisant un moule de photoresist complet correspondant à la pièce finale à obtenir avant l'étape de dépôt galvanique du métal de la pièce dans le moule. Seules des pièces multi-niveaux dont les projections des niveaux sont incluses l'une dans l'autre sont réalisables par cette méthode. Ce procédé présente également certains inconvénients. En particulier, la croissance galvanique démarre partout et les fronts de croissance se rejoignent et causent des inclusions indésirables.

On connait également du document de brevet EP2405301A1, un moule en photoresist comprenant au moins deux niveaux, les niveaux formés dans le substrat ne comportant que des flancs verticaux et lisses. Un tel procédé a pour inconvénient de nécessiter une large surcroissance pour remplir le deuxième niveau, ce qui peut également provoquer des inclusions indésirables dans les encoignures du moule.

### Résumé de l'invention

La présente invention a pour but de remédier aux inconvénients susmentionnés ainsi qu'à d'autres encore en fournissant un procédé permettant de fabriquer des composants horlogers métalliques multi-niveaux au moyen de la technologie LIGA dans lequel une couche conductrice est associée à une couche de résine pour chaque niveau pour permettre une croissance galvanique fiable dans le cas de composants multiniveaux présentant un élancement moyen à fort du deuxième niveau.

La présente invention a également pour but de fournir un tel procédé qui permet d'éviter la métallisation des flans lors du dépôt de la ou des couches électriquement conductrices.

A cet effet l'invention a pour objet un procédé de fabrication d'un composant horloger comprenant les étapes suivantes :
a) se munir du substrat, y déposer une première couche électriquement conductrice, et appliquer une première couche de résine photosensible ;
b) irradier la première couche de résine à travers un masque définissant un premier niveau du composant et dissoudre les zones non irradiées de la couche de résine photosensible pour faire apparaître par endroit la première couche électriquement conductrice ;
c) déposer localement une deuxième couche électriquement conductrice sur les zones irradiées de la première couche de résine ;
d) appliquer une deuxième couche de résine photosensible recouvrant la structure résultant de l'étape c) ;
e) irradier la deuxième couche de résine à travers un masque définissant un deuxième niveau du composant et dissoudre les zones non irradiées de la deuxième couche de résine photosensible pour former un moule comprenant un premier et un second niveau et faire apparaître par endroit la première couche et la deuxième couche électriquement conductrice ;
f) déposer une couche métallique par électroformage dans le moule à partir de la première couche et de la deuxième couche pour former le composant, la couche atteignant sensiblement la surface supérieure de la deuxième couche de résine photosensible ;
g) usiner par un procédé mécanique la couche métallique à une épaisseur prédéfinie ;
h) réaliser en wafer et par usinage mécanique des géométries supplémentaires (chanfreins, lamages,...) sur la face supérieure du composant;
i) éliminer successivement le substrat, les couches conductrices et la résine pour libérer le composant.

Ce procédé permet donc la réalisation de pièces multiniveaux.

Conformément à d'autres variantes avantageuses de l'invention :
- la deuxième couche électriquement conductrice est déposée à travers un masque chablon ;
- la deuxième couche électriquement conductrice est mise en oeuvre par dépôt global sur toutes les surfaces exposées (flancs compris) puis retirée intégralement sauf sur la surface supérieure de la première couche de résine, où elle a été protégée au moyen d'une épargne déposée par tamponnage ;
- la deuxième couche électriquement conductrice est déposée via l'impression d'une encre ou d'une résine conductrice ;
- ladite première couche et ladite deuxième couche électriquement conductrice sont du type Au, Ti, Pt, Ag, Cr, Pd ou un empilement d'au moins deux de ces matériaux ;
- le substrat est en silicium ;
- la première couche conductrice présente une épaisseur comprise entre 50nm et 500nm ;
- la deuxième couche conductrice présente une épaisseur comprise entre 50nm et 500nm ;
- après l'étape a) et après l'étape d), on réalise une mise d'épaisseur de la résine par le biais d'un usinage mécanique, et on traite thermiquement la résine ainsi mise d'épaisseur.

Enfin, l'invention se rapporte à un composant horloger, obtenu selon un procédé conforme à l'invention, tel qu'une ancre ou une roue d'échappement par exemple.

On comprend donc que le procédé de l'invention trouve une application particulièrement avantageuse pour la fabrication de composants pour les pièces d'horlogerie.

### Description sommaire des dessins

D'autres caractéristiques et avantages de la présente invention ressortiront plus clairement de la description détaillée qui suit d'un exemple de réalisation d'un procédé selon l'invention, cet exemple étant donné seulement à titre purement illustratif et non limitatif, en liaison avec le dessin annexé sur lequel :

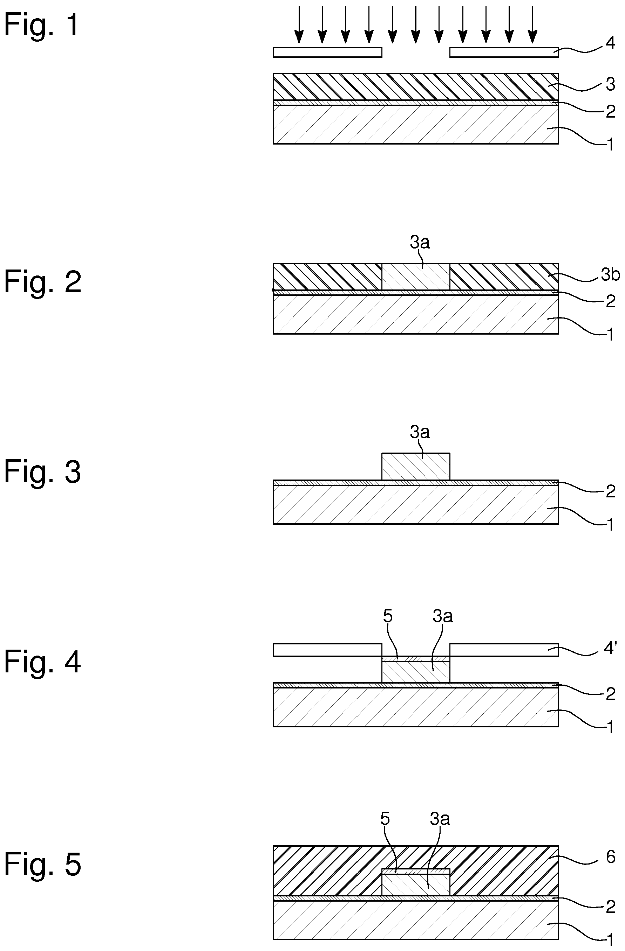

- les figures 1 à 11 illustrent les étapes de procédé d'un mode de réalisation de l'invention en vue de la réalisation d'un composant horloger.

### Description détaillée d'un mode de réalisation préféré

Le substrat 1 utilisé dans l'étape a) du procédé selon l'invention est, par exemple, formé par un substrat en silicium. Lors de la première étape a) du procédé on dépose, par exemple, par un dépôt physique en phase vapeur (PVD), une première couche conductrice 2, c'est-à-dire une couche apte à démarrer un dépôt métallique par voie galvanique. Typiquement, la première couche conductrice 2 est du type Au, Ti, Pt, Ag, Cr ou Pd (figure 1), ou un empilement d'au moins deux de ces matériaux, et présente une épaisseur comprise entre 50nm et 500nm. Par exemple, la première couche conductrice 2 peut être formée d'une sous couche de chrome ou de titane recouverte d'une couche d'or ou de cuivre.

La résine photosensible 3 utilisée dans ce procédé est de préférence une résine de type négative à base d'époxy octofonctionnelle disponible chez Microchem sous la référence SU-8 conçue pour polymériser sous l'action d'un rayonnement UV.

Selon un mode de réalisation particulier de l'invention, la résine se présente sous la forme d'un film sec, la résine est alors appliquée par laminage sur le substrat 1.

Alternativement, la résine photosensible pourrait être un photorésist positif qui est conçu pour se décomposer sous l'action d'un rayonnement UV. On comprendra que la présente invention ne se limite pas à quelques types particuliers de résine photosensible. L'homme du métier saura choisir une résine photosensible convenant à ses besoins parmi toutes les résines connues qui sont adaptées à la photolithographie par UV.

La première couche de résine 3 est déposée sur le substrat 1 par tout moyen approprié, par enduction centrifuge, à la tournette, ou encore par sprayage jusqu'à l'épaisseur souhaitée. Typiquement l'épaisseur de résine est comprise entre 10 µm et 1000 µm, et de préférence entre 30 µm et 300 µm. Selon l'épaisseur désirée et la technique de dépôt utilisée la première couche de résine 3 sera déposée en une ou plusieurs fois.

La première couche de résine 3 est ensuite chauffée typiquement entre 90 et 120° C pendant une durée dépendant de l'épaisseur déposée pour évacuer le solvant (étape de pre-bake). Ce chauffage sèche et durcit la résine.

Selon une étape optionnelle du procédé, la première couche de résine 3 subit une étape de mise à l'épaisseur au cours de laquelle la résine est usinée. De manière à éliminer toutes marques d'usinage et obtenir une surface parfaitement plane, la résine est à nouveau chauffée en sorte de « tendre » sa surface.

L'étape b) suivante illustrée à la figure 2 consiste à irradier la première couche de résine 3 au moyen d'un rayonnement UV à travers un masque 4 définissant le premier niveau du composant à former et ainsi des zones photopolymérisées 3a et des zones non photopolymérisées 3b.

Une étape de recuit (étape de post-bake) de la première couche de résine 3 peut être nécessaire pour compléter la photopolymérisation induite par l'irradiation UV. Cette étape de recuit est effectuée de préférence entre 90°C et 95°C. Les zones photopolymérisées 3a deviennent insensibles à une grande majorité de solvants. Par contre, les zones non photopolymérisées pourront ultérieurement être dissoutes par un solvant.

Ensuite, on dissout les zones non photopolymérisées 3b de la première couche 3 de résine photosensible pour faire apparaître par endroit la première couche conductrice 2 du substrat 1. Cette opération est réalisée par dissolution des zones non photopolymérisées 3b au moyen d'un solvant adéquat, tel que le PGMEA (propylène glycol méthyle éthyle acétate). Un moule en résine photosensible photopolymérisées 3a définissant le premier niveau du composant est ainsi réalisé.

L'étape c) suivante illustrée à la figure 4 consiste à déposer une deuxième couche conductrice 5 sur les zones photopolymérisées 3a lors de l'étape précédente. Cette deuxième couche conductrice 5 peut présenter les mêmes caractéristiques que la première couche conductrice 2, à savoir qu'elle est du type Au, Ti, Pt, Ag, Cr, Pd ou un empilement d'au moins deux de ces matériaux, et présente une épaisseur comprise entre 50nm et 500nm.

Selon un mode de réalisation préférentiel de l'invention, on utilise un masque chablon qui est positionné via un alignement optique. Un tel équipement permet de garantir un bon alignement du masque avec la géométrie des zones photopolymérisées 3a sur le substrat et ainsi garantir un dépôt uniquement sur la surface supérieure de la première couche conductrice 2 tout en évitant un dépôt sur les flancs de la résine photopolymérisées 3a car le masque est maintenu au plus proche du substrat 1.

Selon une variante de l'invention, la deuxième couche électriquement conductrice est mise en oeuvre par dépôt global sur toutes les surfaces exposées (flancs compris) puis retirée intégralement sauf sur la surface supérieure de la première couche de résine, où elle a été protégée au moyen d'une épargne déposée par tamponnage.

L'homme du métier pourrait également envisager la mise en oeuvre d'une impression 3D pour déposer la deuxième couche conductrice 5.

De telles solutions permettent un dépôt sélectif et plus précis de la deuxième couche électriquement conductrice 5, et donc de n'avoir aucun dépôt sur les flancs de la résine photopolymérisées 3a.

L'étape d) suivante illustrée à la figure 5 consiste à déposer une deuxième couche 6 de résine photosensible recouvrant la structure résultant de l'étape précédente. La même résine est utilisée lors de cette étape, et l'épaisseur est supérieure à celle déposée lors de l'étape a). Généralement l'épaisseur varie en fonction de la géométrie du composant que l'on souhaite obtenir.

Selon une étape optionnelle du procédé, la deuxième couche de résine 6 subit une étape de mise à l'épaisseur au cours de laquelle la résine est usinée mécaniquement. De manière à éliminer toutes marques d'usinage et obtenir une surface parfaitement plane, la résine est à nouveau chauffée de façon à « tendre » sa surface.

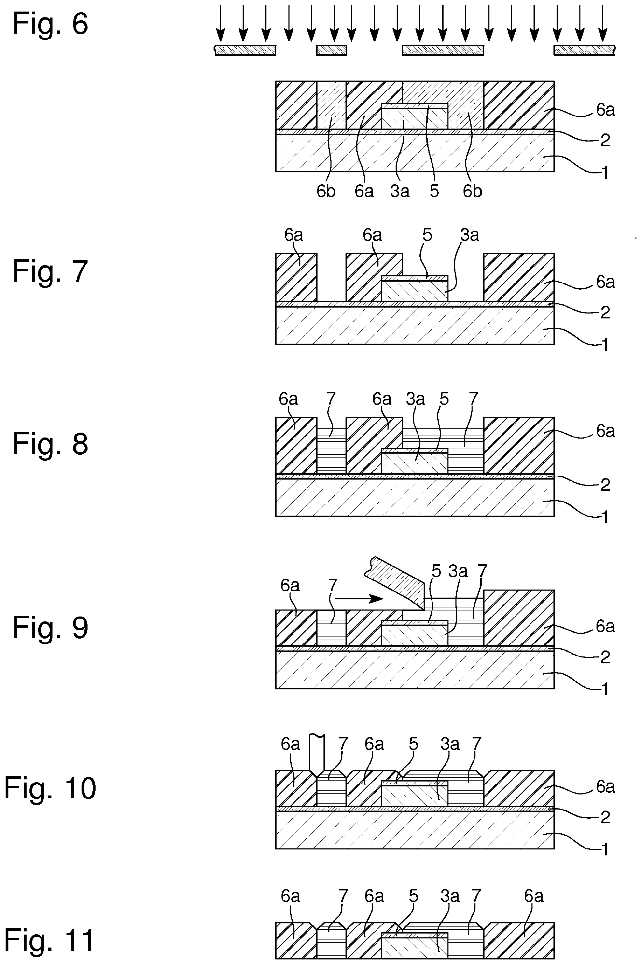

L'étape e) suivante illustrée à la figure 6 consiste à irradier la deuxième couche 6 de résine à travers un masque 4" définissant un deuxième niveau du composant et dissoudre les zones 6b non irradiées de la deuxième couche 6 de résine photosensible. A la fin de cette étape (figure 7), on obtient un moule comprenant un premier et un second niveau laissant apparaître par endroit la première couche 2 électriquement conductrice et la deuxième couche 5 électriquement conductrice.

L'étape f) suivante illustrée à la figure 8 consiste à déposer dans le moule, par électroformage ou dépôt galvanique, une couche 7 d'un métal à partir des première couche 2 et deuxième couche 5 électriquement conductrice jusqu'à former un bloc atteignant préférentiellement une hauteur inférieure à la hauteur du moule, cela permettant une meilleure tenue mécanique lors d'un usinage ultérieur. Par métal dans ce contexte sont bien entendu compris les alliages métalliques. Typiquement, le métal sera choisi parmi l'ensemble comprenant le nickel, le cuivre, l'or ou l'argent, et, comme alliage, l'or-cuivre, le nickel-cobalt, le nickel-fer, le nickel-phosphore, ou encore le nickel-tungstène. En général, la structure métallique multicouche est entièrement réalisée dans le même alliage ou métal. Toutefois, il est également possible de changer de métal ou d'alliage au cours de l'étape de déposition galvanique de manière à obtenir une structure métallique comportant au moins deux couches de natures différentes.

Les conditions d'électroformage, notamment la composition des bains, la géométrie du système, les tensions et densités de courant, sont choisis pour chaque métal ou alliage à électrodéposer selon les techniques bien connues dans l'art de l'électroformage.

L'étape g) suivante illustrée à la figure 9 consiste à usiner par un procédé mécanique la couche métallique 7 à une épaisseur prédéfinie par l'épaisseur du composant à réaliser.

L'étape h) suivante illustrée à la figure 10 consiste à réaliser des opérations d'usinage mécanique telles que des chanfreinages sur les bords de la face visible du composant par exemple, ou encore des taraudages ou des lamages dans le composant. Les opérations dépendront bien évidemment de la géométrie du composant final que l'on souhaite obtenir.

L'étape i) consiste à libérer le composant en éliminant par une succession d'étapes de gravure, humide ou sèche, le substrat, les couches conductrices ou les couches de résine, opérations familières à l'homme du métier.

Par exemple la première couche conductrice 2 et le substrat 1 sont éliminés au moyen d'une gravure humide, ce qui permet de libérer le composant du substrat 1 sans l'endommager. Notoirement, le substrat en silicium peut être gravé avec une solution à base d'hydroxyde de potassium (KOH).

A l'issue de cette première séquence, on obtient un composant pris dans les première et deuxième couches de résine, la deuxième couche conductrice 5 étant également encore présente par endroit.

Une 2^{e} séquence consiste à éliminer la première couche 3 et la deuxième couche 6 de résine au moyen de gravures plasma O₂, espacées de gravures humides des couches métalliques intermédiaires.

A l'issue de cette étape, les composants obtenus peuvent être nettoyés, et éventuellement repris sur une machine-outil pour opérer des usinages ou une terminaison esthétique. A ce stade, les pièces peuvent être directement utilisées ou bien soumises à divers traitements décoratifs et/ou fonctionnels, typiquement des dépôts physiques ou chimiques.

Selon une étape optionnelle, après l'étape a) et l'étape d) on effectue une mise à l'épaisseur par une opération d'usinage de chaque couche de résine 3, 6. Avantageusement, cette opération permet de contrôler finement la géométrie des pièces à l'échelle du substrat 1 (wafer). Une fois la résine mise d'épaisseur, un traitement thermique est réalisé pour s'affranchir des traces d'usinage.

Le procédé de l'invention trouve une application particulièrement avantageuse pour la fabrication de composants pour pièces d'horlogerie, tels que des ressorts, des ancres, des roues, etc. Grâce à ce procédé, on peut obtenir des composants robustes et qui présentent une bonne fiabilité au niveau des géométries.

## Revendications

1. Procédé de fabrication d'un composant horloger comprenant les étapes suivantes :
a) se munir du substrat (1), y déposer une première couche (2) électriquement conductrice, et appliquer une première couche de résine photosensible (3) ;
b) irradier la première couche de résine (3) à travers un masque (4) définissant un premier niveau du composant et dissoudre les zones (3b) non irradiées de la couche de résine photosensible (3) pour faire apparaître par endroit la première couche (2) électriquement conductrice;
c) déposer localement une deuxième couche électriquement conductrice (5) sur les zones (3a) irradiées de la première couche de résine (3) ;
d) appliquer une deuxième couche de résine photosensible (6) recouvrant la structure résultant de l'étape c) ;
e) irradier la deuxième couche de résine (6) à travers un masque (4") définissant un deuxième niveau du composant et dissoudre les zones (6b) non irradiées de la deuxième couche de résine photosensible (6) pour former un moule comprenant un premier et un second niveau et faire apparaître par endroit la première couche (2) et la deuxième couche (5) électriquement conductrice ;
f) déposer une couche métallique (7) par électroformage dans le moule à partir de la première couche (2) et de la deuxième couche (5) pour former le composant, la couche (7) atteignant sensiblement la surface supérieure de la deuxième couche de résine photosensible (6) ;
g) usiner par un procédé mécanique la couche métallique (7) à une épaisseur prédéfinie ;
h) réaliser en wafer et par usinage mécanique des géométries supplémentaires (chanfreins, lamages,...) sur la face supérieure du composant ;
i) éliminer successivement le substrat, les couches conductrices et la résine pour libérer le composant.

2. Procédé selon la revendication 1, **caractérisé en ce que** la deuxième couche électriquement conductrice (5) est déposée à travers un masque chablon (4').

3. Procédé selon la revendication 1, **caractérisé en ce que** lors de l'étape c), la deuxième couche électriquement conductrice (5) est mise en oeuvre par dépôt global sur toutes les surfaces exposées (flancs compris) puis retirée intégralement sauf sur la surface supérieure de la première couche de résine, où elle a été protégée au moyen d'une épargne déposée par tamponnage.

4. Procédé selon la revendication 1, **caractérisé en ce que** lors de l'étape c), la deuxième couche électriquement conductrice (5) est déposée via l'impression d'une encre ou une résine conductrice.

5. Procédé selon l'une des revendications précédentes, **caractérisé en ce que** ladite première couche (2) et ladite deuxième couche (5) électriquement conductrice sont du type Au, Ti, Pt, Ag, Cr, Pd.

6. Procédé selon l'une des revendications précédentes, **caractérisé en ce que** le substrat (1) est en silicium.

7. Procédé selon l'une des revendications précédentes, **caractérisé en ce que** la première couche conductrice (2) présente une épaisseur comprise entre 50nm et 500nm.

8. Procédé selon l'une des revendications précédentes, **caractérisé en ce que** la deuxième couche conductrice (5) présente une épaisseur comprise entre 50nm et 500nm.

9. Procédé selon l'une des revendications précédentes, **caractérisé en ce que** :
- après l'étape a) et après l'étape d), on réalise une mise d'épaisseur de la résine par le biais d'un usinage mécanique ;
- on traite thermiquement la résine mise d'épaisseur.

10. Composant horloger obtenu selon un procédé conforme à l'une des revendications 1 à 8.
